# EUROPEAN PATENT SPECIFICATION

(11) **EP 0 416 878 B1**
(45) Date of publication and mention of the grant of the patent: **28.12.1994**
(21) Application number: 90309676.6
(22) Date of filing: 04.09.1990
(51) Int. Cl.: H05K 13/00

(54) **Electronic component apparatus and method of mounting electronic component**
Vorrichtung für elektronische Bauteile und Verfahren für die Bestückung der elektronischen Bauteile
Dispositif pour pièces de construction électroniques et procédé pour le montage de ces pièces de construction électroniques

(30) Priority: 06.09.1989 JP 230935/89
(43) Date of publication of application: 13.03.1991
(73) Proprietor: MATSUSHITA ELECTRIC INDUSTRIAL CO., LTD., Kadoma-shi, Osaka-fu, 571 (JP)
(72) Inventor: Oyama, Kenshu, Kasuya-Gun, Fukuoka (JP)
(74) Representative: Dawson, Elizabeth Ann

(56) References cited:
- EP-A- 0 062 335
- EP-A- 0 118 689
- EP-A- 0 189 290
- AT-B- 36 799
- JP-A-60 171 000

## Description

### FIELD OF THE INVENTION

This invention relates to an apparatus for and a method of mounting an electronic component and, more particularly, to means for accurately mounting an electronic component required to be mounted with high mounting accuracy such as a quad flat package (QFP) having leads in four directions.

### DESCRIPTION OF THE PRIOR ART

There is known an electronic component mounting apparatus having a carrier turntable at which a number of suction nozzles of electronic components are aligned along a circumferential direction (e.g., see Fig. 4 of Japanese Patent Application Laid-Open No. 60-171000.). The electronic component mounting apparatus of this type takes up electronic components provided at an electronic component delivery unit by the indexing rotation of a carrier turntable, and feeds and mounts the electronic components on a printed circuit board positioned on X-axis table and Y-axis table. The electronic components mounting apparatus is widely employed as a high speed mounting apparatus since it can mount three or more electronic components per second on the printed circuit board.

The electronic component taken up by the suction nozzle is deviated in the directions X, Y and Θ. In order to mount the electronic component on the printed circuit board, this positional deviation must be corrected. A recognition unit such as a CCD camera is provided as positional deviation correcting means on the way of an electronic component feeding passage by the indexing rotation of the carrier turntable in the conventional electronic component mounting apparatus. Thus, the positional deviations of the electronic component in the directions X, Y and Θ are detected by the recognition unit. The positional deviation of the electronic component in the direction Θ (rotating direction) is corrected by rotating the nozzle in the direction Θ, and the positional deviations of the electronic component in the directions X and Y are corrected by driving X-axis table and Y-axis table to move the printed circuit board in the directions X and Y.

Similar apparatus is shown in EP-A-0062335. Electronic components are presented to a suction nozzle by a delivery unit, the suction nozzle being positioned over a table for supporting a printed circuit board. The positions of the component and the board itself are observed by respective image pick-up devices and corrections are made by moving the table in X and Y directions parallel to its support surface, and rotating the suction nozzle.

Recently, electronic components having leads such as QFP have been frequently mounted on a printed circuit board. The electronic component having such leads is hardly mounted on the printed circuit board by the above-described carrier turntable type mounting apparatus due to the reasons described below in the paragraphs (i) and (ii).
(i) Recently, electronic components are requested for high density high integration. This introduces a trend of an increase in the number of leads, up to 200 or more. Therefore, the lateral width and pitch of the leads are made extrafine (e.g., 0.5 mm or less). Thus, the mounting accuracy is severely required that much, but it is extremely difficult to precisely observe the leads so as to satisfy the requested accuracy by a camera.
(ii) The electronic components having leads are increased in size, up to 5 cm or more of one side thereof. In order to catch the large-sized electronic component in the visual field of the camera, the magnification of the camera must be reduced, but if the magnification is decreased, its observing accuracy is indispensably lowered.

By the reasons as described above, capacitor chips, resistor chips, etc. having relatively low mounting accuracy to be required are mounted on a printed circuit board at a high speed by the carrier turntable type mounting apparatus. However, the electronic components having leads cannot be mounted on the printed circuit board by the above-mentioned carrier turntable type mounting apparatus, but are separately mounted at a low speed by a single head type mounting apparatus as shown in Fig. 3 of Japanese Patent Application Laid-Open No. 60-171000.

Since the electronic component having leads like the QFP requires severely high mounting accuracy, the electronic component must be mounted on the printed circuit board separately from the capacitor chips, resistor chips, etc. Accordingly, its working efficiency is not raised. Since two types of mounting apparatus of the carrier turntable type and the single head type are installed and must be operated separately in the technique, facility costs are enhanced, and its production management and maintenance management also require great labour.

Accordingly, an object of this invention is to provide a carrier turntable type electronic component mounting apparatus which can mount accurately an electronic component having leads such as QFP at a high speed.

In order to achieve this and other objects, the present invention provides an electronic component mounting apparatus for mounting an electronic component having a plurality of leads on a printed circuit board, the apparatus comprising:
a delivery unit for delivery of electronic components;
a table movable in X-axis and Y-axis directions for positioning a printed circuit board;
a carrier turntable having a mounting head provided with a nozzle for sucking an electronic component and a motor for rotating the nozzle whereby a component may be picked up by said nozzle and fed to and mounted on said printed circuit board by rotation of said carrier turntable; and
a recognition unit disposed along the feed path of components from said delivery unit to the printed circuit board including a camera for observing positional deviations of an electronic component sucked by said nozzle, characterised in that said apparatus further comprises:
a precise measuring unit positioned to precisely locate the leads of an electronic component whilst moving in the X and/or Y axis direction integrally with said table; and
a horizontally rotating unit for horizontally rotating the printed circuit board positioned on said table.

With the arrangement described above, the electronic component provided at the electronic component delivery unit is sucked to the nozzle of the suction head to be taken up, the electronic component is fed to the recognition unit by the rotation of the carrier turntable, and the positional deviation of the electronic component is roughly observed by the camera of the recognition unit. Then, this electronic component is fed to the X-axis and Y-axis tables. Thereafter, the precise positional deviation of the lead is measured by the precise measuring unit while the X-axis and Y-axis tables are moved in the directions X and Y. Subsequently, the printed circuit board is moved and rotated in the directions X, Y and to Θ correct the positional deviations of the electronic components in the directions X, Y and Θ, and the electronic component is then placed on the printed circuit board.

A second aspect of the invention provides a method of mounting an electronic component having a plurality of leads on a printed circuit board, comprising the steps of:
roughly observing the position of an electronic component held by a suction nozzle by means of a camera and determining the rough deviation of the observed position of the electronic component from a desired position;
roughly correcting for the observed deviation of the electronic component in an X-axis and a Y-axis direction by relatively moving the suction nozzle and a movable table means supporting a circuit board on which the component is to be mounted in an X-axis and Y-axis direction of the circuit board and roughly correcting for the observed deviation of the electronic component in a Θ direction by relatively rotating the suction nozzle and the circuit board around an axis through the electronic component held thereon;
and placing the electronic component on the printed circuit board;
precisely measuring the position of the electronic component held by the suction nozzle by precisely measuring the deviation of a position of at least one lead of the electronic component from a desired position for determining the precise deviation of the observed position of the electronic component from a desired position on the printed circuit board supported on said movable table means;
precisely correcting for the observed deviation of the electronic component in an X-axis and a Y-axis direction by moving said movable table means in the X-axis and Y-axis direction, and precisely correcting for the observed deviation of the electronic component in the Θ direction by relatively rotating the printed circuit board and the component around an axis of rotation which extends in a direction perpendicular to the circuit board.

These and other objects and features of the present invention will become apparent from the following detailed description of a preferred embodiment in conjunction with the attached drawings.

### BRIEF DESCRIPTION OF THE DRAWINGS

Fig. 1 is a plan view of a carrier turntable type electronic component mounting apparatus according to an embodiment of the present invention;
Fig. 2 is a side view of a recognition unit of the apparatus;
Fig,. 3 is a perspective view of a horizontally rotating unit for a printed circuit board of the apparatus;
Fig. 4 is a sectional view of the horizontally rotating unit;
Fig. 5 is a plan view of the same;
Fig. 6 is a front view of a laser unit;
Fig. 7 is a plan view of large and small electronic components; and
Figs. 8(a), 8(b) and 8(c) are plan views of recognition of the recognition unit.

### DESCRIPTION OF THE PREFERRED EMBODIMENT

An embodiment of an electronic component mounting apparatus according to the present invention will now be described with reference to the accompanying drawings.

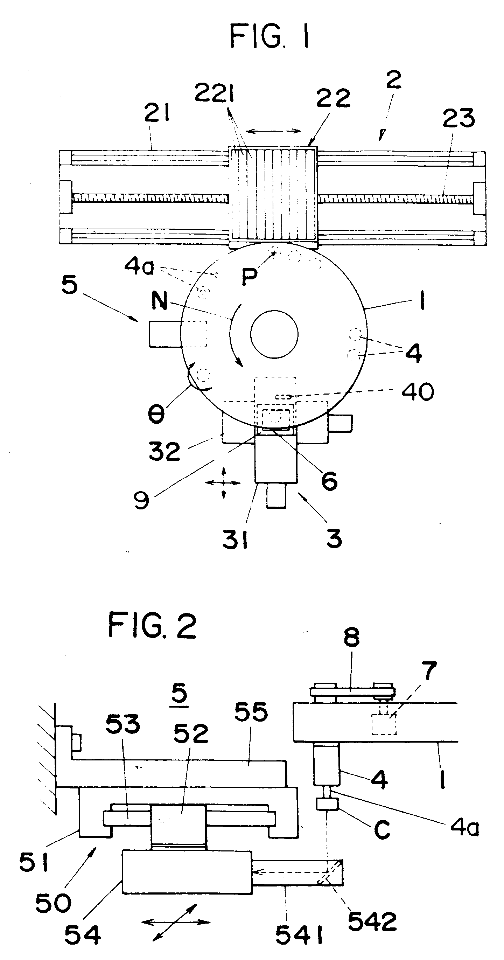

Fig. 1 is a plan view of an electronic component mounting apparatus of the invention. The electronic component mounting apparatus of the embodiment comprises a carrier turntable 1. An electronic component delivery unit 2 and X-axis and Y-axis tables 3 are disposed under the carrier turntable 1. A mounting head 4 has a nozzle 4a for sucking an electronic component, and a number of mounting heads 4 are vertically suspended from the carrier turntable 1 along the circumferential direction. The mounting apparatus also comprises a recognition unit 5 for recognizing the electronic component sucked to the lower end of the nozzle 4a from below, and the recognition unit 5 is arranged on an electronic component feeding passage between the delivery unit 2 and the X-axis and Y-axis tables 3.

The delivery unit 2 is composed by placing a supply unit 22 on the upper portion of a movable table 21. A feed screw 23 is rotated by a motor (not shown) to slide the supply unit 22 laterally and to position a desired electronic component to a takeup position of the nozzle 4a. The supply unit 22 is composed by arranging a plurality of cassettes 221 formed by winding an electronic component sealing tape on a reel. The X-axis and Y-axis tables 3 are composed of an X-axis table 31 and a Y-axis table 32, and a printed circuit board 6 is positioned thereon.

The carrier turntable 1 is index-rotated in a counterclockwise direction N to vertically move the nozzle 4a at the takeup position P to take up the electronic component, to feed the electronic component to the X-axis and Y-axis tables 3 thereby to place the electronic component on the printed circuit board 6. The positional deviations of the electronic component in the directions X, Y and ϑ are observed on the way by the recognition unit 5. The indexing rotation means an intermittent rotation.

Fig. 2 is a side view of the recognition unit 5. The recognition unit 5 has a X-axis and Y-axis moving unit 50 arranged on a supporting frame 51 to slidably move a X-axis slide 52 and a Y-axis slide 53 in the directions X and Y, respectively, and a camera 54 attached to the lower portion of the X-axis slide 52. A mounting plate 55 is provided. The barrel 541 of the camera 54 is extended to the lower portion of the mounting head 4 vertically suspended from the carrier turntable 1 to recognize the electronic component C sucked to the lower end of the nozzle 4a from below. The camera 54 has a reflecting mirror 542 provided at the barrel 541. A ϑ-direction rotating motor is arranged in the carrier turntable 1 to rotate the nozzle 4a at an angle ϑ around the axis through a belt 8 according to the recognition result of the camera 54.

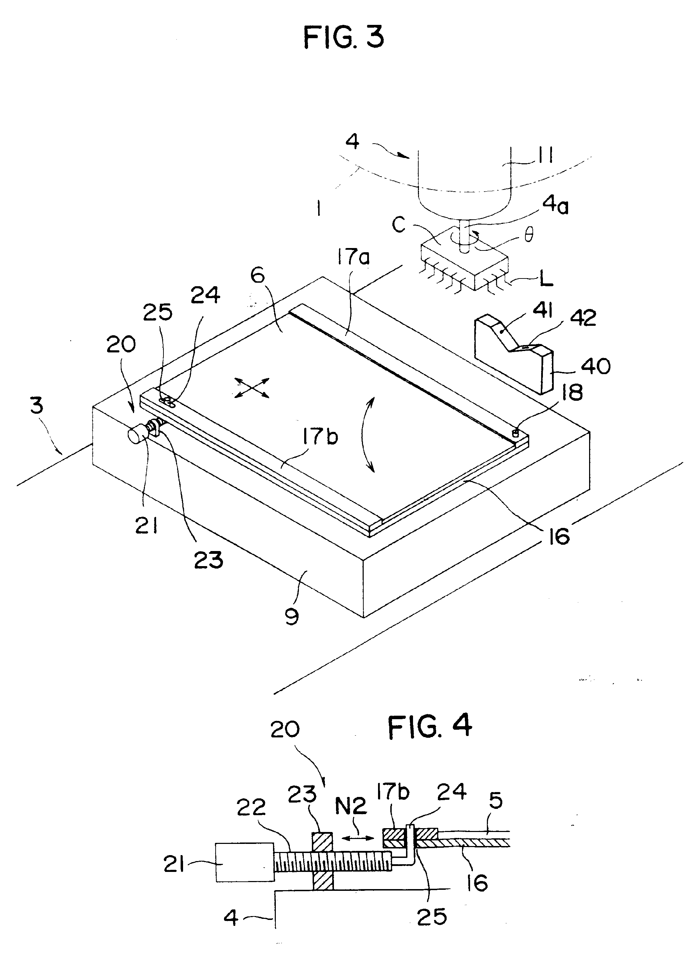

Fig. 3 shows positioning means for the printed circuit board 6 on the X-axis and Y-axis tables 3. A table section 9 is provided on the X-axis and Y-axis tables 3, and a placing unit 16 for the printed circuit board 6 is disposed on the upper surface of the table section. Clampers 17a and 17b for clamping the printed circuit board 6 from both sides to position it are provided at both side of the placing unit 16. The corners of the placing unit 16 are horizontally rotatably supported onto the table section 9 via hinges 18.

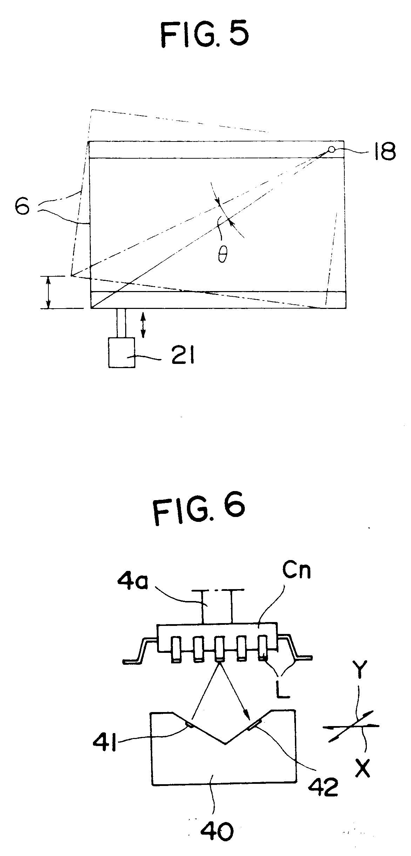

Fig. 4 shows a driving unit 20 for horizontally rotating the placing unit 16. The placing unit 16 has a motor 21, a feed screw 22, and a nut 23 provided on the X-axis and Y-axis tables 3. A hook type pin 24 is extended to the end of the feed screw 22. The end is engaged with a long hole 25 opened at the placing unit 16. Accordingly, when the motor 21 is driven, the feed screw 22 is reciprocated in the longitudinal direction N2, and the placing unit 16 is horizontally rotated at the hinge 18 as a center. Fig. 5 simply shows the horizontal rotation of the placing unit 16. More specifically, the placing unit 16, the hinge 18, the driving unit 20 constitute the horizontally rotating unit for horizontally rotating the printed circuit board 6.

In Figs. 3 and 6, a precise measuring unit 40 is provided on the X-axis and Y-axis tables 3 as a laser unit, and has a light emitting unit 41 for emitting a laser light, and a photodetector 42. The laser unit 40 emits a laser light to the lead L of the electronic component C sucked to the nozzle 4a while moving in the directions X and Y integrally with the X-axis and Y-axis tables 3. Thus, the reflected light is received by the photodetector 42 thereby to precisely measure the position of the lead L, and the detailed operation will be described later.

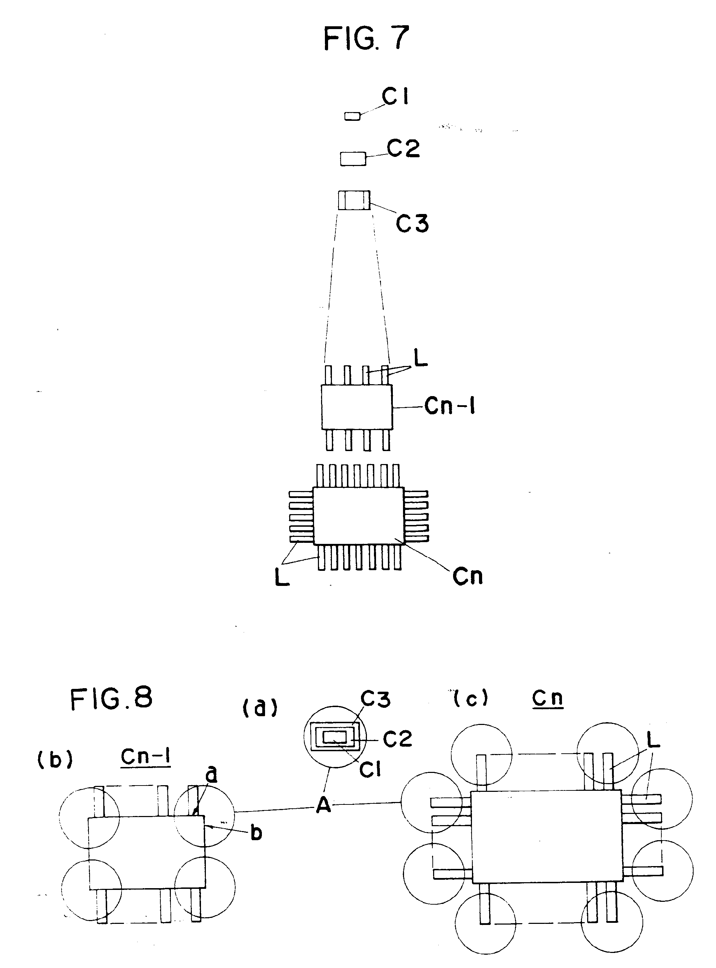

As shown in Fig. 7, the size and shape of the electronic component C of this type are various, and there are resistor chips C1, C2, capacitor chips C2 of relatively small size, an electronic component Cn such as a small outline package (SOP) roughly having leads L in two directions, an electronic component Cn-1 such as QFP densely having leads L in 4 directions. Among them, the resistor chip C1, C2 and the capacitor chip C3 are generally low in mounting accuracy required. Since the electronic component Cn in which a number of extrafine leads 1 protrude must be accurately bonded at the leads L to the pattern of the printed circuit board 6, the required mounting accuracy is extremely high. The mounting apparatus of the invention is for mounting a number of type of electronic components C1 to Cn on the printed circuit board 6 at a high speed while satisfying the required mounting accuracy, and the mounting works of the electronic components C1 to Cn will be described with reference to the drawings.

Figs. 8 shows the manner of observing the electronic component by the recognition unit 5. In the case of relatively small electronic components C1 to C3, the required mounting accuracy is relatively low. Accordingly, as shown in Fig. 8(a), the entire electronic component is introduced into the visual field A of the camera 54 to be simultaneously observed, thereby observing the positional deviations of the electronic component in the directions X, Y and ϑ. Then, the electronic component is fed and placed on the printed circuit board 6 positioned to the X-axis and Y-axis tables 3 by the indexing rotation of the carrier turntable 1. The motor 7 is rotated on the way to rotate the nozzle 4a at an angle ϑ to correct the positional deviation of the component in the direction ϑ, and to move the X-axis and Y-axis tables 3 in the directions X and Y to correct the positional deviations of the component in the directions X and Y.

The electronic components Cn-1, Cn are required for a high mounting accuracy. Accordingly, if the magnification of the camera 54 is lowered to simultaneously observe the entire electronic component, the observation error is extremely increased. Then, in the case of the electronic component Cn-1, the X-axis and Y-axis moving unit 50 is driven to slide the camera 54 in the directions X and Y thereby to introduce the corner of the electronic component Cn-1 into the visual field A (See Fig. 8(b).), the positional deviations of the perpendicularly crossing vertical and lateral sizes a and b are detected to detect the positional deviations of the electronic component Cn-1. Such a recognition work may be conducted only at one corner of the electronic component Cn-1, but it takes a long time required for the recognition work but detects the positional deviations more accurately to raise the mounting accuracy to move the camera 54 in the directions X and Y by driving the X-axis and Y-axis moving unit 50 so as to detect as many as possible at the four corners.

As shown in Fig. 8(c), in the case of the electronic component Cn having the leads L in the four directions, the corners of the leads L may be introduced into the visual field A of the camera to be observed. Or, since the electronic component Cn having the leads in the four directions are required for extremely high mounting accuracy, it can raise the mounting accuracy to recognize as many as possible at the eight corners.

As described above, the electronic components Cn-1, Cn are observed for more corners and leads L by moving the camera 54 in the directions X and Y, thereby precisely observing the positional deviations in the directions X, Y and ϑ. The observation by the camera 54 is rough to detect substantially accurate position of the lead L and to accurately position the lead L at the laser emitting position by the laser unit 40.

Then, the electronic components Cn-1, Cn are fed to the printed circuit board 6 on the X-axis and Y-axis tables 3 by the indexing rotation of the carrier turntable 1, but it is difficult by the motor 7 to accurately correct the positional deviations of the electronic component in the direction ϑ due to the performance of the motor 7. Therefore, more accurate correction will be executed as below.

When the electronic components Cn-1, Cn are fed onto the X-axis and Y-axis tables 3, the laser unit 40 is moved under the lead L sucked to the nozzle 4a. Then, the laser light is emitted toward the lead L while the lead rows protruding from the sides of the electronic components Cn-1, Cn is being moved laterally at the laser unit 40, the reflected light is received by the photodetector 42 thereby to accurately measure the positional deviation of the lead L (See Fig. 6.) Thereafter, the motor 21 is driven on the basis of the measured result to horizontally rotate the printed circuit board 6 to thereby correct the positional deviation of the lead L in the direction ϑ, and the X-axis and Y-axis tables 3 are moved to correct the positional deviations in the directions X and Y, and the electronic components Cn-1, Cn are placed on the printed circuit board 6.

As described above, the mounting apparatus of the invention observes, in the case of the electronic components C1 to C3 having lower required mounting accuracy, the positional deviation of the electronic components in the directions X, Y, ϑ by the camera 54, corrects the positional deviation in the direction ϑ by the motor 7 to feed and place it on the printed circuit board 6. Further, the mounting apparatus roughly observes, in the case of the electronic components Cn-1, Cn having high required mounting accuracy, the lead L by the camera 54 so as to position the lead L at the laser light emitting position by the laser unit 40, detects the accurate positional deviation of the lead L by precisely measuring the lead L by the laser unit 40, drives the horizontally rotating unit on the basis of the detected result for the positional deviation in the direction ϑ thereby to correct it by horizontally rotating the printed circuit board 6. Therefore, the electronic components C1 to C3 can be mounted at a high speed, and since the electronic components Cn-1, Cn are required for the measuring time by the laser unit 40, the mounting speed is slightly lowered, but the components can be mounted on the printed circuit board 6 in an extremely high accuracy. The precise measuring unit may employ, in addition to the laser unit, a unit which can precisely measure it such as a linear image sensor.

According to the present invention as described above, the electronic components having low required mounting accuracy such as the resistor chips, capacitor chips are mounted on the printed circuit board by detecting the positional deviation by the camera of the recognition unit and correcting the positional deviation by the motor for rotating at the angle ϑ, while the electronic components having leads of SOP or QFP and high required mounting accuracy are accurately mounted on the printed circuit board by roughly observing by the camera, then precisely measuring by the precise measuring unit, driving the horizontally rotating unit on the basis of the measured result, accurately correcting the positional deviations. Therefore, a number of types of the electronic components can be accurately mounted on the printed circuit board with satisfactory operability while satisfying the required mounting accuracies thereof.

## Claims

1. An electronic component mounting apparatus for mounting an electronic component having a plurality of leads on a printed circuit board, the apparatus comprising:
a delivery unit (2) for delivery of electronic components;
a table (9) movable in X-axis and Y-axis directions for positioning a printed circuit board;
a carrier turntable (1) having a mounting head (4) provided with a nozzle (4a) for sucking an electronic component and a motor (7) for rotating the nozzle (4a) whereby a component may be picked up by said nozzle and fed to and mounted on said printed circuit board by rotation of said carrier turntable; and
a recognition unit (5) disposed along the feed path of components from said delivery unit to the printed circuit board including a camera for observing positional deviations of an electronic component sucked by said nozzle,
characterised in that said apparatus further comprises:
a precise measuring unit (40) positioned to precisely locate the leads of an electronic component whilst moving in the X and/or Y axis direction integrally with said table (9); and
a horizontally rotating unit (20) for horizontally rotating the printed circuit board positioned on said table (9).

2. An electronic component mounting apparatus according to claim 1, wherein said precise measuring unit 40 is a laser unit.

3. An electronic component mounting apparatus according to claim 1, wherein said precise measuring unit is a linear image sensor.

4. An electronic component mounting apparatus according to claim 1,2 or 3, wherein said recognition unit is arranged in an X-axis and Y-axis moving unit.

5. An electronic component mounting apparatus according to any preceding claim including a placing unit (16) for supporting a printed circuit board pivotably mounted on said table 9.

6. An electronic component mounting apparatus according to claim 5 in which the horizontally rotating unit (20) operates to rotate the placing unit (16) about its pivot axis.

7. A method of mounting an electronic component having a plurality of leads on a printed circuit board, comprising the steps of:
roughly observing the position of an electronic component held by a suction nozzle (4a) by means of a camera (54) and determining the rough deviation of the observed position of the electronic component from a desired position;
roughly correcting for the observed deviation of the electronic component in an X-axis and a Y-axis direction by relatively moving the suction nozzle (4a) and a movable table means (9) supporting a circuit board on which the component is to be mounted in an X-axis and Y-axis direction of the circuit board and roughly correcting for the observed deviation of the electronic component in a Θ direction by relatively rotating the suction nozzle (4a) and the circuit board around an axis through the electronic component held thereon;
and placing the electronic component on the printed circuit board;
precisely measuring the position of the electronic component held by the suction nozzle (4a) by precisely measuring the deviation of a position of at least one lead of the electronic component from a desired position for determining the precise deviation of the observed position of the electronic component from a desired position on the printed circuit board supported on said movable table means (1);
precisely correcting for the observed deviation of the electronic component in an X-axis and a Y-axis direction by moving said movable table means in the X-axis and Y-axis direction, and precisely correcting for the observed deviation of the electronic component in the Θ direction by relatively rotating the printed circuit board and the component around an axis of rotation which extends in a direction perpendicular to the circuit board.

8. A method as claimed in claim 7 in which the step of roughly correcting the relative position of the electronic component and the circuit board comprises moving the circuit board in the X and Y-axis directions and rotating the nozzle in the Θ direction.

9. A method as claimed in claim 7 or 8 in which the step of precisely correcting the relative position of the electronic component and the circuit board comprises moving the circuit board in the X-axis and Y-axis directions and rotating the circuit board around the axis of rotation which is perpendicular to the circuit board.

10. A method of mounting an electronic component having a plurality of leads on a printed circuit board, comprising the steps of:
picking up and holding the electronic component by a suction nozzle (4a) on a mounting head (4) on a carrier turntable (1);
roughly observing the position of the electronic component held by the suction nozzle by means of a camera and determining the rough deviation of the observed position of the electronic component from a desired position;
roughly correcting for the observed deviation of the electronic component in an X-axis and a Y-axis direction by moving a movable table means supporting a circuit board on which the component is to be mounted in an X-axis and Y-axis direction of the circuit board and, roughly correcting for the observed deviation of the electronic component in a Θ direction by rotating the suction nozzle around an axis through the electronic component held thereon;
and placing the electronic component on the printed circuit board;
characterised in that the electronic component is moved to a field of vision precisely measuring the position of the electronic component held by the suction nozzle by a precise measuring means on said movable table means for determining the precise deviation of the observed position of the electronic component from a desired position on the printed circuit board supported on said movable table means;
precisely correcting for the observed deviation of the electronic component in an X-axis and a Y-axis direction by moving said movable table means in the X-axis and Y-axis direction, and precisely correcting for the observed deviation of the electronic component in the Θ direction by rotating the printed circuit board around an axis of rotation which extends in a direction perpendicular to the circuit board by rotating a circuit board support rotatably mounted on said movable table means around said last-mentioned axis.

## Patentansprüche

1. Elektronikbauteil-Bestückungsvorrichtung zur Bestückung eines elektronischen Bauteils, das eine Vielzahl von Anschlüssen besitzt, auf einer gedruckten Leiterplatte, wobei die Vorrichtung aufweist:
eine Zuführeinheit (2) zur Zuführung von elektronischen Bauteilen;
einen Tisch (9), der in X-Achsen- und Y-Achsen-Richtung zur Positionierung einer gedruckten Leiterplatte bewegbar ist;
einen Trägerdrehtisch (1), der einen Bestückungskopf (4) besitzt, der mit einer Düse (4a) zum Ansaugen eines elektronischen Bauteils und einem Motor (7) zur Drehung der Düse (4a) ausgestattet ist, wobei ein Bauteil durch die Düse aufgenommen und auf die gedruckte Leiterplatte durch Drehung des Trägerdrehtischs zugeführt und darauf montiert werden kann; und
eine Erkennungeinheit (5), die entlang des Zuführdurchgangswegs der Bauteile von der Zuführeinheit zu der gedruckten Leiterplatte angeordnet ist, die eine Kamera zur Beobachtung der stellungsmäßigen Abweichungen eines elektronischen Bauteils, das durch die Düse angesaugt ist, umfaßt, dadurch gekennzeichnet, daß die Vorrichtung weiterhin aufweist:
eine genaue Meßeinheit (40), die so positioniert ist, um genau die Anschlüsse eines elektronischen Bauteils zu orten, während es in der X- und/oder Y-Achsen-Richtung integral mit dem Tisch (9) bewegt wird, und
eine horizontale Dreheinheit (20) zur horizontalen Drehung der gedruckten Leiterplatte, die an dem Tisch (9) positioniert ist.

2. Elektronikbauteil-Bestückungsvorrichtung nach Anspruch 1, wobei die genaue Meßeinheit (40) eine Lasereinheit ist.

3. Elektronikbauteil-Bestückungsvorrichtung nach Anspruch 1, wobei die präzise Meßeinheit ein linearer Abbildungssensor ist.

4. Elektronikbauteil-Bestückungsvorrichtung nach Anspruch 1, 2 oder 3, wobei die Erkennungseinheit in einer X-Achsen- und Y-Achsen- Bewegungseinheit angeordnet ist.

5. Elektronikbauteil-Bestückungsvorrichtung nach einem der vorhergehenden Ansprüche, die eine Plaziereinheit (16) zum Tragen einer gedruckten Leiterplatte umfaßt, die schwenkbar an dem Tisch (9) befestigt ist.

6. Elektronikbauteil-Bestückungsvorrichtung nach Anspruch 5, bei der die horizontale Dreheinheit (20) so arbeitet, um die Plaziereinheit (16) um deren Schwenkachse zu drehen.

7. Verfahren zum Bestücken eines elektronischen Bauteils, das eine Vielzahl von Anschlüssen besitzt, auf einer gedruckten Leiterplatte, das die folgenden Verfahrensschritte umfaßt:
grobes Beobachten der Position eines elektronischen Bauteils, das an einer Ansaugdüse (4a) gehalten wird, mittels einer Kamera (54) und Bestimmung der groben Abweichung der beobachteten Position des elektronischen Bauteils von einer erwünschten Stellung;
grobe Korrektur der beobachteten Abweichung des elektronischen Bauteils in einer X-Achsen- und einer Y-Achsen-Richtung durch relative Bewegung der Ansaugdüse (4a) und einer bewegbaren Tischeinrichtung (9), die eine Leiterplatte trägt, auf der das Bauteil in einer X-Achsen- und Y-Achsen-Richtung der Leiterplatte bestückt werden soll, und grobe Korrektur der beobachteten Abweichung des elektronischen Bauteils in einer ϑ -Richtung durch relative Drehung der Ansaugdüse (4a) und der Leiterplatte um eine Achse, durch die das elektronische Bauteil daran gehalten wird;
und Plazierung des elektronischen Bauteils auf der gedruckten Leiterplatte;
genaue Messung der Position des elektronischen Bauteils, das durch die Ansaugdüse (4a) gehalten wird, durch genaue Messung der Abweichung einer Position mindestens eines Anschlusses des elektronischen Bauteils von einer erwünschten Stellung zur Bestimmung der genauen Abweichung der beobachteten Stellung des elektronischen Bauteils von einer erwünschten Stellung auf der gedruckten Leiterplatte, die auf der bewegbaren Tischeinrichtung (1) gehalten wird;
genaue Korrektur der beobachteten Abweichung des elektronischen Bauteils in einer X-Achsen- und Y-Achsen-Richtung durch Bewegung der bewegbaren Tischeinrichtung in der X-Achsen- und Y-Achsen- Richtung und genaue Korrektur der beobachteten Abweichung des elektronischen Bauteils in der ϑ-Richtung durch relative Drehung der gedruckten Leiterplatte und des Bauteils um eine Drehachse, die sich in einer Richtung rechtwinklig zu der Leiterplatte erstreckt.

8. Verfahren nach Anspruch 7, bei dem der Verfahrensschritt der groben Korrektur der relativen Position des elektronischen Bauteils und der Leiterplatte eine Bewegung der Leiterplatte in den X- und Y-Achsen-Richtungen und Drehung der Düse in der ϑ-Richtung aufweist.

9. Verfahren nach Anspruch 7 oder 8, bei dem der Verfahrensschritt der genauen Korrektur der relativen Position des elektrischen Bauteils und der Leiterplatte eine Bewegung der Leiterplatte in den X- und Y-Achsen-Richtungen und eine Drehung der Leiterplatte um die Drehachse, die rechtwinklig zu der Leiterplatte verläuft, aufweist.

10. Verfahren zum Befestigen eines elektronischen Bauteils, das eine Vielzahl von Anschlüssen besitzt, an einer gedruckten Leiterplatte, das folgende Verfahrensschritte aufweist:
Aufnahme und Halten des elektronischen Bauteils durch eine Ansaugdüse (4a) an einem Bestückungskopf (4) an einem Trägerdrehtisch (1);
grobes Beobachten der Position des elektronischen Bauteils, das durch die Ansaugdüse gehalten ist, mittels einer Kamera und Bestimmung der groben Abweichung der beobachteten Position des elektronischen Bauteils von einer erwünschten Stellung;
grobe Korrektur der beobachteten Abweichung des elektronischen Bauteils in einer X- und einer Y-Achsen-Richtung durch Bewegen einer bewegbaren Tischeinrichtung, die eine Leiterplatte trägt, auf der das Bauteil in einer X-Achsen- und Y-Achsen-Richtung auf der Leiterplatte befestigt werden soll, und grobe Korrektur der beobachteten Abweichung des elektronischen Bauteils in einer ϑ-Richtung durch Drehung der Ansaugdüse um eine Achse, durch die das elektronische Bauteil daran gehalten wird;
und Plazierung des elektronischen Bauteils auf der gedruckten Leiterplatte;
dadurch gekennzeichnet, daß das elektronische Bauteil in einem Sichtfeld zur genauen Messung der Stellung des elektronischen Bauteils, das durch die Ansaugdüse gehalten wird, bewegt wird, und zwar durch eine genaue Meßeinrichtung an der bewegbaren Tischeinrichtung zur Bestimmung der genauen Abweichung der beobachteten Position des elektronischen Bauteils von einer erwünschten Position auf der gedruckten Leiterplatte, die auf der bewegbaren Tischeinrichtung getragen wird;
genaue Korrektur der beobachteten Abweichung des elektronischen Bauteils in einer X-Achsen- und einer Y-Achsen-Richtung durch Bewegung der bewegbaren Tischeinrichtung in der X-Achsen- und Y-Achsen-Richtung und genaue Korrektur der beobachteten Abweichung des elektronischen Bauteils der ϑ-Richtung durch Drehung der gedruckten Leiterplatte um eine Drehachse, die sich in einer Richtung rechtwinklig zu der Leiterplatte erstreckt, durch Drehung eines Leiterplattenträgers, der drehbar an der bewegbaren Tischeinrichtung befestigt ist, und zwar um die letztgenannte Achse.

## Revendications

1. Appareil de montage de composant électronique pour monter un composant électronique ayant une pluralité de sorties sur une carte à circuit imprimé, l'appareil comprenant :
une unité de fourniture (2) pour fournir des composants électroniques ;
une table (9) mobile dans des directions selon l'axe des X et l'axe des Y pour positionner une carte à circuit imprimé ;
une table tournante de support (1) ayant une tête de montage (4) pourvue d'un embout (4a) pour aspirer un composant électronique et un moteur (7) pour faire tourner l'embout (4a) grâce à laquelle un composant peut être prélevé par ledit embout et envoyé vers et monté sur ladite carte à circuit imprimé par rotation de ladite table tournante de support ; et
une unité de reconnaissance (5) disposée le long du chemin d'alimentation des composants à partir de ladite unité de fourniture à la carte à circuit imprimé comprenant une caméra pour observer des déviations de position d'un composant électronique aspiré par ledit embout,
caractérisé en ce que ledit appareil comprend en outre :
une unité de mesure précise (40) positionnée pour localiser avec précision les sorties d'un composant électronique tout en se déplaçant dans la direction selon l'axe des X et/ou des Y intégralement avec ladite table (9) ; et
une unité de rotation horizontale (20) pour faire tourner horizontalement la carte à circuit imprimé positionnée sur ladite table (9).

2. Appareil de montage de composant électronique selon la revendication 1, dans lequel ladite unité de mesure précise (40) est une unité laser.

3. Appareil de montage de composant électronique selon la revendication 1, dans lequel ladite unité de mesure précise est un capteur linéaire d'image.

4. Appareil de montage de composant électronique selon la revendication 1, 2 ou 3, dans lequel ladite unité de reconnaissance est disposée dans une unité de déplacement selon l'axe des X et l'axe des Y.

5. Appareil de montage de composant électronique selon l'une quelconque des revendications précédentes comprenant une unité de positionnement (16) pour supporter une carte à circuit imprimé de façon pivotante montée sur ladite table (9).

6. Appareil de montage de composant électronique selon la revendication 5 dans lequel l'unité tournant horizontalement (20) fonctionne pour faire tourner l'unité de positionnement (16) autour de son axe de rotation.

7. Procédé de montage d'un composant électronique ayant une pluralité de sorties sur une carte à circuit imprimé, comprenant les étapes de :
observation grossière de la position d'un composant électronique maintenu par un embout d'aspiration (4a) au moyen d'une caméra (54) et détermination de la déviation grossière de la position observée du composant électronique à partir d'une position voulue ;
correction grossière de la déviation observée du composant électronique dans une direction selon l'axe des X et l'axe des Y par un déplacement relatif de l'embout d'aspiration (4a) et d'un dispositif de table mobile (9) supportant un circuit imprimé sur lequel le composant est à monter dans une direction selon l'axe des X et l'axe des Y du circuit imprimé et correction grossière de la déviation observée du composant électronique dans une direction ϑ par une rotation relative de l'embout d'aspiration (4a) et du circuit imprimé autour d'un axe à travers le composant électronique maintenu sur celui-ci ;
et positionnement du composant électronique sur la carte à circuit imprimé ;
mesure avec précision de la position du composant électronique maintenu par l'embout d'aspiration (4a) en mesurant avec précision la déviation d'une position d'au moins une sortie du composant électronique à partir d'une position voulue pour déterminer la déviation précise de la position observée du composant électronique à partir d'une position voulue sur la carte à circuit imprimé supportée sur ledit dispositif de table mobile (1) ;
correction avec précision de la déviation observée du composant électronique dans une direction selon l'axe des X et l'axe des Y en déplaçant ledit dispositif de table mobile dans la direction selon l'axe des X et l'axe des Y, et correction avec précision de la déviation observée du composant électronique dans la direction ϑ par une rotation relative de la carte à circuit imprimé et du composant autour d'un axe de rotation qui s'étend dans une direction perpendiculaire au circuit imprimé.

8. Procédé selon la revendication 7 dans lequel l'étape de correction grossière de la position relative du composant électronique et du circuit imprimé comprend le déplacement du circuit imprimé dans les directions selon l'axe des X et des Y et la rotation de l'embout dans la direction ϑ.

9. Procédé selon la revendication 7 ou 8 dans lequel l'étape de correction avec précision de la position relative du composant électronique et du circuit imprimé comprend le déplacement du circuit imprimé dans les directions selon l'axe des X et l'axe des Y et la rotation du circuit imprimé autour de l'axe de rotation qui est perpendiculaire au circuit imprimé.

10. Procédé de montage d'un composant électronique ayant une pluralité de sorties sur une carte à circuit imprimé, comprenant les étapes de :
prélèvement et maintien du composant électronique par un embout d'aspiration (4a) sur une tête de montage (4) sur une table tournante de support (1) ;
observation grossière de la position du composant électronique maintenu par l'embout d'aspiration au moyen d'une caméra et détermination de la déviation grossière de la position observée du composant électronique à partir d'une position voulue ;
correction grossière de la déviation observée du composant électronique dans une direction selon l'axe des X et l'axe des Y en déplaçant un dispositif de table mobile supportant un circuit imprimé sur lequel le composant est à monter dans une direction selon l'axe des X et l'axe des Y du circuit imprimé et, correction grossière de la déviation observée du composant électronique dans une direction ϑ par rotation de l'embout d'aspiration autour d'un axe à travers le composant électronique maintenu sur celui-ci ;
et positionnement du composant électronique sur la carte à circuit imprimé ;
caractérisé en ce que le composant électronique est déplacé vers un champ de vision en mesurant avec précision la position du composant électronique maintenu par l'embout d'aspiration par un dispositif de mesure précise sur ledit dispositif de table mobile pour déterminer la déviation précise de la position observée du composant électronique à partir d'une position voulue sur la carte à circuit imprimé supportée sur ledit dispositif de table mobile ;
correction avec précision de la déviation observée du composant électronique dans une direction selon l'axe des X et l'axe des Y en déplaçant ledit dispositif de table mobile dans la direction selon l'axe des X et l'axe des Y, et correction avec précision de la déviation observée du composant électronique dans la direction ϑ par rotation de la carte à circuit imprimé autour d'un axe de rotation qui s'étend dans une direction perpendiculaire au circuit imprimé par rotation d'un support de circuit imprimé monté de façon rotative sur ledit dispositif de table mobile autour dudit dernier axe mentionné.
